(19) **Europäisches Patentamt**
**European Patent Office**
**Office européen des brevets**

(11) **EP 1 738 185 B1**

(12) **EUROPÄISCHE PATENTSCHRIFT**

(45) Veröffentlichungstag und Bekanntmachung des Hinweises auf die Patenterteilung:
**19.10.2011 Patentblatt 2011/42**

(51) Int Cl.:
*G01R 13/32* *(2006.01)*       *G01R 27/28* *(2006.01)*

(21) Anmeldenummer: **05741725.5**

(22) Anmeldetag: **20.04.2005**

(86) Internationale Anmeldenummer:
**PCT/EP2005/004235**

(87) Internationale Veröffentlichungsnummer:
**WO 2005/103736 (03.11.2005 Gazette 2005/44)**

(54) **SIGNALVERARBEITUNGSVORRICHTUNG MIT SYNCHRONER TRIGGERUNG**

SIGNAL PROCESSING DEVICE WITH SYNCHRONOUS TRIGGERING

DISPOSITIF DE TRAITEMENT DE SIGNAUX AVEC DECLENCHEMENT SYNCHRON

(84) Benannte Vertragsstaaten:
**DE FR GB**

(30) Priorität: **23.04.2004 DE 102004019966**

(43) Veröffentlichungstag der Anmeldung:
**03.01.2007 Patentblatt 2007/01**

(73) Patentinhaber: **Rohde & Schwarz GmbH & Co. KG
81671 München (DE)**

(72) Erfinder:
• **SCHMIDT, Kurt
85567 Grafing (DE)**

• **FREIDHOF, Markus
85614 Kirchseeon (DE)**

(74) Vertreter: **Körfer, Thomas
Mitscherlich & Partner
Patent- und Rechtsanwälte
Postfach 33 06 09
80066 München (DE)**

(56) Entgegenhaltungen:
**EP-A- 1 074 845        EP-A- 1 156 338
US-A1- 2003 036 872     US-A1- 2003 220 753
US-A1- 2004 117 143**

EP 1 738 185 B1

**Beschreibung**

Die Erfindung betrifft eine Signalverarbeitungsvorrichtung mit verbesserter Triggerung.

Bei der Auswertung von digitalen Signalen, beispielsweise bei Meßgeräten für digitale Telekommunikationssignale, insbesondere für diverse Mobilfunk-Standards, ist es notwendig, verschiedene Triggerungen auf das Eingangssignal vorzunehmen.

Zum Stand der Technik wird beispielsweise auf die DE 101 59 911 A1 verwiesen, die sich bereits mit der Triggerung von digitalen Eingangssignalen beschäftigt. Diese Druckschrift behandelt unterschiedliche Triggermethoden auf der Frame-Ebene und der Symbol-Ebene. Eine Realisierung der Triggerung in den digitalen Signalverarbeitungseinheiten auf Blockschaltungsebene ist nicht beschrieben.

Die vorliegende Erfindung geht davon aus, dass die digitale Signalverarbeitungsvorrichtung zwei oder mehrere Signal-Zweige mit jeweils parallel arbeitenden Signalverarbeitungseinheiten aufweist und das Ergebnis der jeweiligen Signalverarbeitungseinheit jeweils in einem Speicher aufgezeichnet wird. Beispielsweise wird in einem ersten Signal-Zweig das Empfangssignal demoduliert während gleichzeitig im anderen Signal-Zweig das Spektrum berechnet wird, wobei es auf den zeitlichen Bezug der beiden Signale ankommt.

EP 1156338 A beschreibt eine SDO - Architektur mit Trigger synchronisierung.

Der Erfindung liegt die Aufgabe zugrunde, für eine Signalverarbeitungsvorrichtung eine Synchronisierung für alle parallel arbeitenden Signal-Zweige zu schaffen.

Die Aufgabe wird durch die Merkmale des Anspruchs 1 gelöst.

wird vorgeschlagen, dass die Aufzeichnungssteuerung zur Steuerung der Aufzeichnung in den Speichern ein in einer Triggerleitung vor den beiden parallel arbeitenden Signalverarbeitungseinheiten angeordnetes Trigger-Schaltelement so ansteuert, dass in beiden Speichern im wesentlichen die gleiche Zeitperiode während einer Post-Trigger-Zeit nach einem Trigger-Zeitpunkt aufgezeichnet wird.

Die Speicher arbeiten vorzugsweise als zyklische Speicher und zeichnen während einer Pre-Trigger-Zeit das Signalverarbeitungsergebnis der jeweiligen Signalverarbeitungseinheit auf. Durch die Triggerung wird erreicht, dass beide parallel arbeitenden Signalverarbeitungseinheiten synchron angesteuert werden und nach Auftreten eines Trigger-Ereignisses, also ab einem gemeinsamen Trigger-Zeitpunkt, während einer jeweils gleich langen Post-Trigger-Zeit synchron aufzeichnen.

Die Ausgangssignalfolge in den Signalverarbeitungsblöcken, aus welchen die Signalverarbeitungseinheiten der beiden Signal-Zweige aufgebaut sind, wird gegenüber der jeweiligen Eingangssignalfolge verzögert sein. Es ist dann sinnvoll, auch das Trigger-Signal um einen Betrag zu verzögern, welcher der Verzögerung der Ausgangssignalfolge gegenüber der Eingangssignalfolge, also der Gruppenlaufzeit durch den jeweiligen Signalverarbeitungsblock, entspricht.

Die Unteransprüche enthalten vorteilhafte Weiterbildungen der Erfindung.

Mittels einer Umschalteinrichtung kann zwischen einem externen Trigger-Signal und beispielsweise zwei internen Trigger-Signalen umgeschaltet werden. Ein erstes internes Trigger-Signal kann von der Aufzeichnungssteuerung erzeugt werden, während ein zweites internes Trigger-Signal unmittelbar von einer der Signalverarbeitungseinheiten in Abhängigkeit von einem internen Trigger-Ereignis erzeugt wird. Dieses interne Trigger-Ereignis kann beispielsweise das Überschreiten einer Pegelschwelle sein und wird beispielsweise erzeugt, indem der Absolutbetrag des Eingangssignals fortwährend überwacht wird. Überschreitet der Pegel die vorgegebene Schwelle, kann davon ausgegangen werden, dass ein für die Aufzeichnung relevanter Signalabschnitt folgt.

Das externe Trigger-Signal ist in der Regel asynchron und muss erst z. B. durch eine flankensensitive Abtasteinheit synchronisiert werden. Dabei ist es vorteilhaft, zur Erhöhung der Genauigkeit zwischen zwei Bereichen des Taktsignals, das als Referenzsignal für die Synchronisierung dient, zu unterscheiden. Die beiden Bereiche können beispielsweise die positive und die negative Halbwelle dieses Taktsignals sein. In einem Trigger-Offset-Register kann dann ein spezielles Bit des Trigger-Signals, das zur Unterscheidung zwischen diesen beiden Bereichen dient, gespeichert werden.

Wenn in einzelnen Signalverarbeitungsblöcken eine Dezimation der digitalen Eingangssignalfolge durch Unterabtastung auftritt, führt dies zu einer Reduktion der Genauigkeit der Trigger-Position, wenn als Zeit-Raster für das Trigger-Signal die Abtastperiode des Ausgangssignals, welche um den Down-Sampling-Faktor größer als die Abtastperiode des Eingangssignals ist, verwendet wird. Es ist dann vorteilhaft, in diesen dezimierenden Signalverarbeitungsblöcken ein spezielles Trigger-Offset-Register vorzusehen, in welchem gespeichert wird, um welche zeit das Trigger-Signal durch die Verringerung der Abtastrate verschoben wurde.

Für denjenigen Signalverarbeitungsblock, der ein internes Trigger-Signal auslöst, ist es sinnvoll eine Zeiterfassungseinrichtung beispielsweise im Form eines Zählers vorzusehen, der erfaßt, welche Zeit das Trigger-Signal nach Einspeisung am Eingang der Signalverarbeitungsvorrichtung bis zu dem das Trigger-Signal auslösenden Signalverarbeitungsblock benötigt. Dies ermöglicht eine entsprechende Rückrechnung des Triggerzeitpunkts in die Vergangenheit. Ist das Trigger-Ereignis z. B. das Überschreiten einer bestimmten Signalschwelle, so interessiert es rückwirkend, wann der den Schwellwert überschreitende Signalabschnitt in den Eingang der Signalverarbeitungsvorrichtung eingelaufen ist. Dies kann dann entsprechend rekonstruiert werden.

Ein Ausführungsbeispiel der Erfindung wird nachfolgend unter Bezugnahme auf die Zeichnung näher beschrieben. In der Zeichnung zeigen:

Fig. 1 ein Blockschaltbild eines Ausführungsbeispiel der erfindungsgemäßen Signalverarbeitungs- vorrichtung;

Fig. 2 eine schematische Darstellung des zeitlichen Ablaufs einer Messung mit Pre- und Post-Trigger- Zeit;

Fig. 3 eine Veranschaulichung der Erzeugung der Trigger-Information in den unterschiedlichen Bereichen des Eingangstakts;

Fig. 4 die Zuordnung eines Eingangswerts zu einem Trigger-Ereignis;

Fig. 5 die Verzögerung des Triggersignals in einen Block mit vier Pipeline-Registern;

Fig. 6 ein Beispiel, bei welchem in einen Signalverarbeitungs-Block um den Faktor 4 dezimiert wird;

Fig. 7 eine Veranschaulichung des Trigger-Offset;

Fig. 8 ein erstes Ausführungsbeispiel für die Realisierung der Pre-Triggerung;

Fig. 9 ein zweites Ausführungsbeispiel für die Realisierung der Pre-Triggerung und

Fig. 10 ein Beispiel für die interne Trigger-Erzeugung bei einem Cordic-Block.

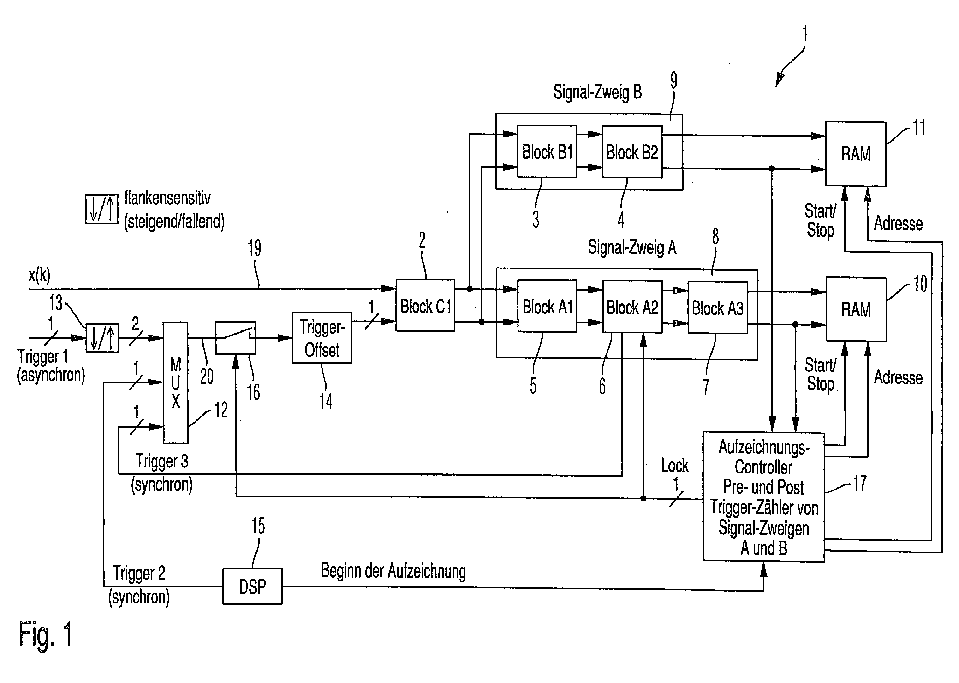

In Fig. 1 ist das vereinfachte Blockschaltbild der Signalverarbeitungsvorrichtung 1 gezeigt. Die Signalverarbeitung der digitalen Eingangsfolge $x(k)$ besteht im Ausführungsbeispiel aus einem gemeinsamen Block 2 (Block C1) gefolgt von den beiden parallelen Signal-Zweigen A und B, welche wiederum aus einzelnen Signalverarbeitungs-Blöcken 3 und 4 (Blöcke B1 und B2) bzw. 5, 6 und 7 (Blöcke A1, A2, A3) bestehen. In den einzelnen Blöcken werden typische Signalverarbeitungsaufgaben wie beispielsweise FIR-Filterungen mit und ohne Dezimierung, spektrale Verschiebungen oder die Umrechnung von kartesischen Koordinaten in Polarkoordinaten durchgeführt. Während die digitale Signalfolge auf einer Signalleitung 19 transportiert wird, ist parallel dazu in allen Stufen der Signalverarbeitung einer Triggerleitung 20 für das Triggersignal vorhanden.

Eine Besonderheit ist der Einsatz der beiden parallelen Signal-Zweige A und B in den Signalverarbeitungseinheiten 8 und 9. Damit kann bespielsweise im Signalzweig A das Empfangssignal demoduliert werden, während gleichzeitig im Signalzweig B vom betrachteten Zeitintervall das Spektrum berechnet wird. In der in Fig. 1 betrachteten Anwendung handelt es sich um eine Offline-Analyse, weshalb die Ausgangsfolgen zunächst in Speichern (RAMs) abgelegt und später ausgelesen werden. Dabei ist für den Signalzweig A ein erster Speicher 10 und für den Signalzweig B ein zweiter Speicher 11 vorhanden.

Es besteht die Möglichkeit, die Eingangssignale der Signal-Zweige A und B durch Triggersignale zu markieren. Damit ist man in der Lage, einen gemeinsamen Zeitpunkt in den beiden Ausgangsfolgen der Signal-Zweige A und B zu markieren und damit den Zeitbezug zwischen den Ausgangssignalen wieder herzustellen.

Zur Markierung solcher Zeitpunkte stehen mehrere Triggersignale zur Auswahl: Durch den eingangsseitigen Multiplexer 12 kann zwischen den Triggersignalen *Trigger* 1, *Trigger* 2 oder *Trigger* 3 ausgewählt werden. Das Triggersignal *Trigger* 1 markiert Zeitpunkte der Eingangsfolge $x(k)$. Dieses Triggersignal ist asynchron zur Eingangsfolge x(k) des digitalen Eingangssignals und wird erst durch eine flankensensitive Abtastung in der Abtasteinheit 13 synchronisiert. Durch die Zweiflankenabtastung beträgt die zeitliche Auflösung eine halbe Eingangstaktperiode bei einem Tastverhältnis von eins. Die notwendige Information, ob der Triggerzeitpunkt in der positiven oder negativen Flanke aufgetreten ist, wird im Trigger-Offset-Register 14 abgelegt. Auf dessen detaillierte Beschreibung wird weiter unten eingegangen. Weiterhin sind in den dezimierenden Blöcken jeweils ein Trigger-Offset-Register vorgesehen, damit auch bei Dezimation die Auflösung des Triggerzeitpunktes nicht reduziert wird.

Es besteht die Möglichkeit, einen synchronen Software-Trigger *Trigger* 2 durch den digitalen Signalprozessor 15 (DSP) zu erzeugen. Eine weitere Alternative ist die Verwendung eines intern erzeugten synchronen Triggersignal *Trigger 3* z. B. im Block 6 (Block A2). Mit diesem Triggersignal werden interessierende Ereignisse, wie beispielsweise die Überschreitung eines Pegels, über eine vorgebbare Schwelle markiert.

Das verwendete Triggersignal wird in den einzelnen Blöcken immer so verzögert, daß die Gruppenlaufzeiten durch Pipeline-Register ausgeglichen werden. Damit werden die Signalfolge und das Triggersignal gleichermaßen verzögert, was die Rekonstruktion des Triggerzeitpunktes in der Signalfolge erheblich vereinfacht.

Mit dem Schalterelement 16 nach dem Multiplexer 12 können die Triggersignale gesperrt werden. Damit wird sichergestellt, daß die Signal-Zweige A und B auf das gleiche Triggerereignis reagieren.

Im Aufzeichnungs-Controller 17 sind die Pre- und Posttriggerzähler implementiert, damit ein vorgebbares Beobachtungsintervall vor und nach dem Triggerereignis in den Speichern 10 und 11 abgelegt wird. Da die Verzögerungen und auch die Ausgangs-Taktraten der beiden Signalzweige in der Regel unterschiedlich sind, müssen für jeden Zweig separate Zähler vorgesehen werden.

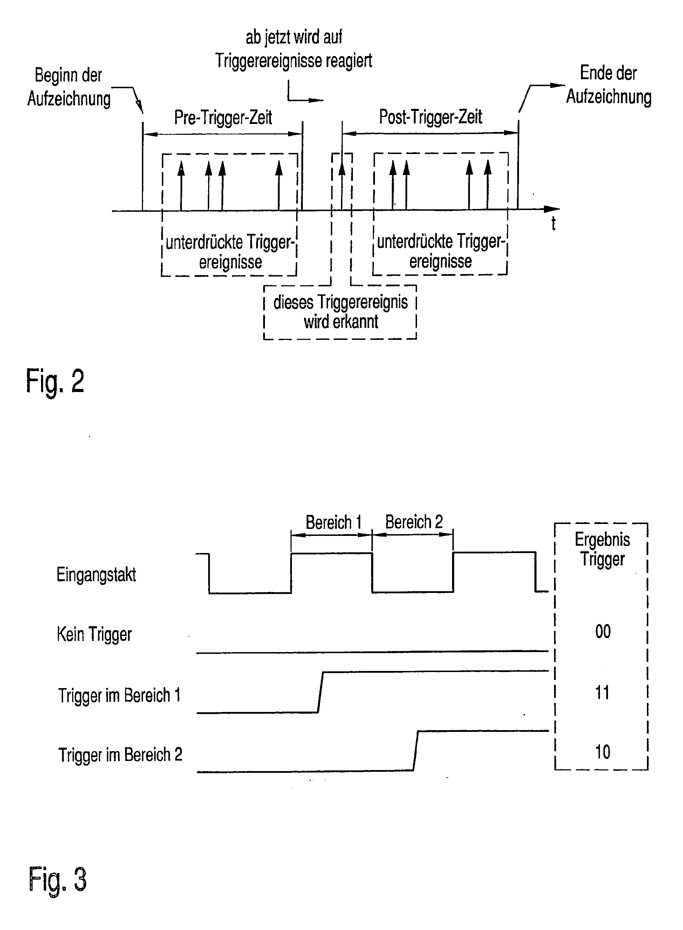

Fig. 2 zeigt den zeitlichen Ablauf einer Messung mit Pre-und Post-Trigger-Zeit. Die Aufzeichnung in die RAMs 10 und 11 erfolgt in folgenden Schritten:

1. Der digitale Signalprozessor 15 gibt das Kommando "Beginn der Aufzeichnung". Ab diesem Zeitpunkt werden die Ausgangsfolgen der Zweige A und B in die Speicher 10 und 11 geschrieben. Das Beschreiben der Speicher 10 und 11 erfolgt zyklisch nach Art eines Ringspeichers, d.h. nach Beschreiben aller Speicherzellen werden die zuerst beschriebenen Speicherzellen wieder überschrieben.

2. Pre-Trigger-Zeit:

Innerhalb der Pre-Trigger-Zeit wird aufgezeichnet, ohne daß auf Triggerereignisse reagiert wird. Damit wird sichergestellt, dass vor dem Triggerzeitpunkt ein Zeitintervall im Speicher 10 und 11 gespeichert wird, das mindestens die Dauer der vorgegebenen Pretriggerzeit besitzt. Erst nach Ablauf der Pre-Trigger-Zeit darf auf ein Triggerereignis reagiert werden, d.h. das Steuersignal wird auf *Lock* = 1 gesetzt und schließt das eingangsseitige Schalterelement 16.

3. Post-Trigger-Zeit:

Tritt nach Ablauf der Pre-Trigger-Zeit ein Triggerereignis auf, fängt die Post-Trigger-Zeit an. Gleichzeitig wird das Steuersignal auf *Lock* = 0 zurückgesetzt, d.h. alle nachfolgenden Triggerereignisse werden ignoriert. Nach Ablauf der Post-Trigger-Zeit wird die Aufzeichnung gestoppt.

Nachfolgend wird auf die Einsynchronisierung des Triggersignals eingegangen. Das asynchrone Triggersignal *Trigger* 1 wird mit beiden Flanken des Eingangstakts abgetastet. So ergibt sich eine höhere Zeitauflösung des Triggerereignisses. Besitzt der Eingangstakt das optimale Tastverhältnis von eins, ergibt sich eine zeitliche Auflösung von einer halben Eingangstaktperiode. Zwar reduziert sich bei unsymmetrischem Tastverhältnis die zeitliche Auflösung, jedoch ist sie immer noch genauer als bei der konventionellen Einflankenabtastung mit einer zeitlichen Auflösung von nur einer Eingangstaktperiode. Aufgrund der höheren Zeitauflösung durch die Zweiflankenabtastung erzeugt die Abtastung der asynchronen Triggereingänge eine 2-Bit-Information. Fig. 3 zeigt, welche Triggerinformation in den Bereichen des Eingangstakts erzeugt wird.

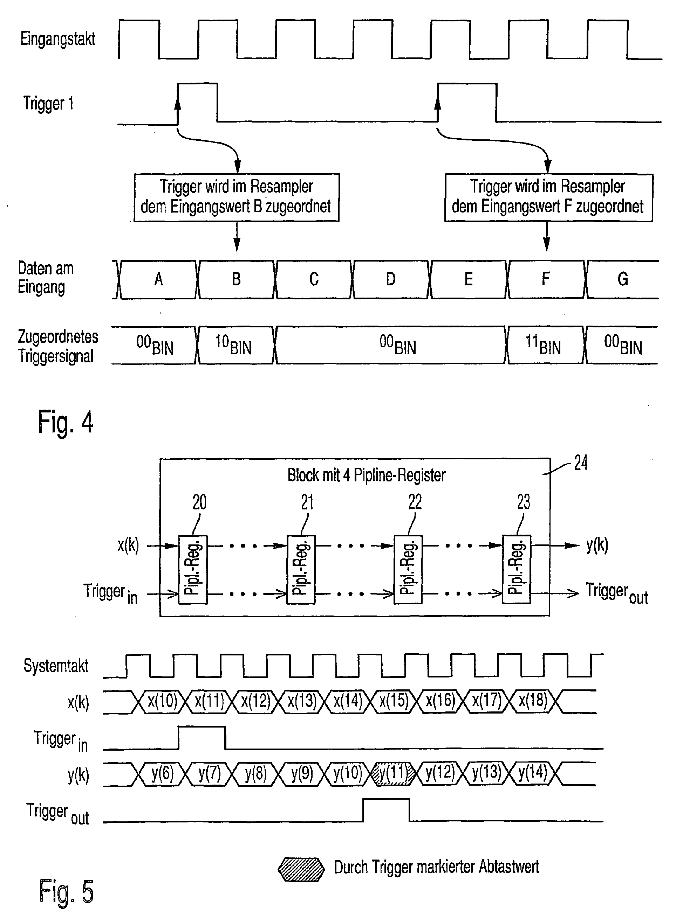

Von diesen beiden Bits wird auf den Ausgang des Trigger-Offset-Registers 14 nur das MSB (Most Significant Bit, höchstsignifikantes Bit) gegeben. Das LSB (Lowest Significant Bit, am wenigsten signifikantes Bit) wird im Trigger-Offset-Register 14 gespeichert. Fig. 4 zeigt, welchem Eingangswert das Triggerereignis zugeordnet wird.

Eine weitere Erhöhung der Auflösung wird erreicht, wenn die Frequenz vom Eingangstakt bei unveränderter Taktrate der Eingangsfolge $x(k)$ um den Faktor $N$ erhöht wird. Bei beispielsweise einer Verdopplung ($N$ = 2) ergibt sich eine zeitliche Auflösung von einer viertel Taktperiode der Eingangsfolge. Aufgrund des größeren Wertebereichs der Offset-Werte muss das Trigger-Offset-Register 14 dann entsprechend breiter ausgelegt werden.

Das durch den Multiplexer 12 ausgewählte Triggersignal wird über das steuerbare Schalterelement 16 geleitet. Damit kann der Triggereingang gesperrt werden. Das Konzept dabei ist, dass nur dann ein Triggerereignis in die Signalverbarbeitung gelassen wird, wenn es auch tatsächlich die Post-Trigger-Zeit auslöst. Ob das Schalterelement 16 sperrt, wird über die Steuerleitung *Lock* vom Aufzeichnungs-Controller 17 bestimmt. Das Schalterelement 16 weist vorzugsweise folgende zwei Betriebsarten auf:

In der Betriebsart "Single" wird, nachdem der Schalter 16 geschlossen wurde, wird nur das erste Triggerereignis durchgelassen. Danach der Schalter 16 automatisch wieder geöffnet und somit der Triggereingang gesperrt. So ist sichergestellt, dass dieses Triggerereignis die Post-Trigger-Zeit von Zweig A und B startet. Andernfalls könnten unterschiedliche Triggerereignisse die Zähler starten. Von diesem Triggerereignis werden in den Blöcken mit Dezimation die Trigger-Offsets gespeichert. Erst ein erneutes Entsperren des Triggereingangs lässt das nächste Triggerereignis durch. Nachfolgend wird immer von dieser Betriebsart ausgegangen.

In der Betriebsart "All" hingegen werden nach dem Entsperren des Triggereingangs alle Triggerereignisse durchgelassen. Diese Betriebsart kann gewählt werden, wenn der zeitliche Bezug der Triggerereignisse zwischen den beiden Signal-Zweigen nicht interessiert.

Nach dem Schalterelement 16 wird der Offset des Triggerereignisses ausgewertet. In diesem Fall ist der Offset die Information, ob der Trigger im Bereich 1 oder Bereich 2 (vgl. Fig. 4) des Eingangstakts aufgetreten ist. Das Trigger-Offset-Register 14 wird vom ersten Triggerereignis, welches das Schalterelement 16 passiert, gesetzt. Es muss im Betrieb möglich sein, das Trigger-Offset-Register 14 wieder zu löschen.

Im Signalpfad werden Pipeline-Register verwendet. Aus folgendem Grund muß das Triggersignal entsprechend auch durch die gleiche Anzahl von Pipeline-Registern verzögert werden: Nach Ablauf einer Messung muß bei der Ermittlung des genauen Triggerzeitpunktes nicht gerechnet werden, wieviel Pipeline-Register bei dieser Messung benutzt wurden. Dies führt zu einer wesentliche Erleichterung. Fig. 5 zeigt, wie das Triggersignal in einem Block 24 mit vier Pipeline-Registern 20 - 23 verzögert wird. Fig. 5 zeigt nicht das tatsächliche Timing, sondern soll nur das Prinzip verdeutlichen. Durch die Signale *Trigger*in und *Trigger*out ist in der Eingangs- und in der Ausgangsfolge markiert, bei welchem Abtastwert ein Triggerereignis aufgetreten ist. Im Beispiel ist dies beim 11. Eingangswert der Fall. Durch die vier Pipeline-Register 20 - 23 wird das Eingangssignal um vier Eingangstakte verzögert.

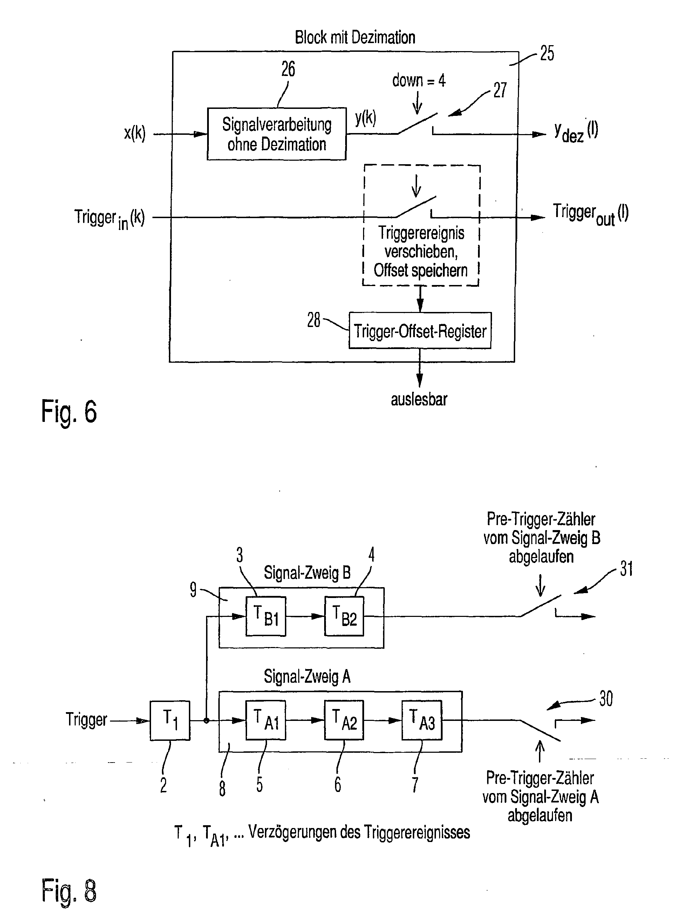

Damit weiterhin von Block zu Block nur der Wert markiert wird, bei dem das Triggerereignis aufgetreten ist, muß bei einem Block mit Dezimation auch das Triggerereignis dezimiert werden. Fig. 6 zeigt ein Beispiel, bei dem in einem Block um den Faktor 4 dezimiert wird. Bedingt durch die Multiraten-Signalverarbeitung müssen Triggersignale in den Modulen mit einer Umsetzung der Abtastrate (Resampling) auch umgesetzt werden. Durch den Prozess der Dezimation von Triggerereignissen ergibt sich aber eine Reduktion der zeitlichen Auflösung der Triggersignale. Wird eine Unterabtastung durchgeführt, muss das Triggerereignis auf den nächsten Ausgangswert verschoben werden. Dieser Prozess reduziert die zeitliche Auflösung auf eine Ausgangstaktperiode. Wie in Fig. 6 gezeigt, kann ein Block 25 mit Dezimation gedanklich in eine Signalverarbeitung 26 ohne Dezimation und eine Down-Sampling-Einheit 27 zerlegt werden. Um bei ganzzahligen Down-Sampling keinen Verlust der zeitlichen Auflösung zu erhalten, wird die Zeit, um die das Triggerereignis verschoben wird, in einem Trigger-Offset-Register 28 gespeichert.

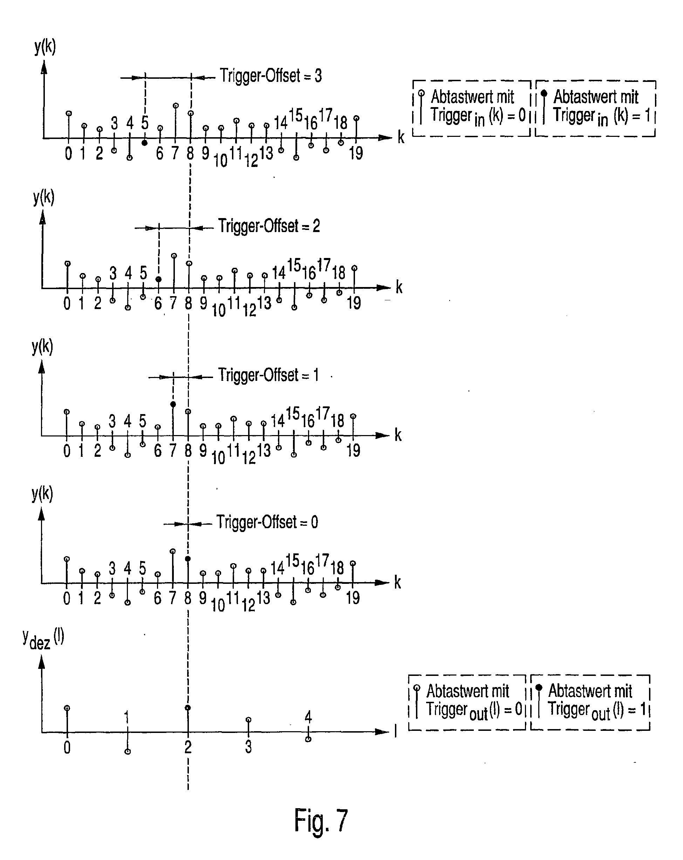

In Fig. 7 wird ein Beispiel für einen Block mit dem Down-Sampling-Faktor vier gezeigt. Bei diesem Down-Sampling gibt es insgesamt vier mögliche Positionen für eine aktive Triggermarkierung in der nicht dezimierten Ausgangsfolge y(k), die zu der gleichen Markierung in der dezimierten Ausgangsfolge $y_{dez}$(l) führen. In dem Beispiel sind alle vier Möglichkeiten dargestellt. Um unterscheiden zu können, wo die Markierung lag, wird der angegebene Trigger-Offset in einem Register, das als Trigger-Offset-Register 28 bezeichnet wird, gespeichert.

In jedem Block mit Down-Sampling muss es für jedes Triggersignal ein Trigger-Offset-Register 28 geben. Würde jede aktive Triggermarkierung das Trigger-Offset-Register 28 setzen, könnte nicht mehr genau zugeordnet werden, welche Markierung nun das Register 28 gesetzt hat. Aus diesem Grund setzt nur die erste aktive Triggermarkierung das Trigger-Offset-Register 28, was durch das Sperren der nachfolgenden Triggerereignisse durch Öffnen des Triggerschalterelements 16 sichergestellt wird. Nachfolgende aktive Markierungen führen zunächst zu keinem Neusetzen des Registers 28.

Damit ergibt sich vom betrachteten Signal-Zweig die einfache Rechenvorschrift zur Berechnung der interessierenden Trigger-Offset-Zeit $T_{Offset\_all}$ durch die Unterabtastung in der abgespeicherten Ausgangsfolge

$$T_{Offset\_all} = \sum_{\alpha=1}^{nof\_dec\_Blocks} Trigger\text{--}Offset(\alpha) \cdot T_{in}(\alpha) \, ,$$

wobei

*Trigger-Offset*($\alpha$) der im Register abgelegte Offset-Wert vom Block $\alpha$,

$T_{in}(\alpha)$ die Eingangstaktperiode vom Block $\alpha$ und

*nof_dec_Blocks* die Anzahl der dezimierenden Blöcke vom betrachteten Signal-Zweig ist.

Bei der Triggerung entstehen zwei wesentliche Probleme:

Die Trigger-Offset-Register 28 in den dezimierenden Blöcken 25 können nur ein Triggerereignis auswerten. Es muss deshalb sichergestellt werden, dass diese Register auch nur bei dem Triggerereignis eingestellt werden, mit dem auch die Post-Trigger-Zeit ausgelöst wird.

Zwischen der Messung im Signal-Zweig A und der Messung im Signal-Zweig B muss ein fester Zeitbezug bestehen. Dies funktioniert nur, wenn beide Zweige auf das gleiche Triggerereignis reagieren.

Zunächst wird erläutert, wie sichergestellt wird, dass alle Offset-Register 28 vom gleichen Triggerereignis eingestellt werden und dieses Triggerereignis auch die Post-Trigger-Zeit auslöst. Würden zu Anfang der Aufzeichnung diese Register 28 zurückgesetzt, wären sie schon vom ersten unterdrückten Triggerereignis gesetzt worden. Werden aber nach Ablauf der Pre-Trigger-Zeit einfach nur die Offset-Register 28 gelöscht, kann es sein, daß sich ein Triggerereignis schon in den Blöcken 2 - 9 befindet und deshalb nicht mehr alle Offset-Register 28 gesetzt werden oder die Offset-Register 28 nicht vom selben Triggerereignis gesetzt werden. Dies macht es notwendig, dass durch das Schalterelement 16 am Eingang erst dann Triggerereignisse zugelassen werden, wenn die Pre-Trigger-Zeit abgelaufen ist. Das hierfür notwendige Steuersignal *Lock* wird im Aufzeichnungs-Controller 17 erzeugt.

Nachfolgend wird die Notwendigkeit des TriggerSchalterelements am Eingang noch genauer im Hinblick darauf erläutert, wie ein gemeinsamer Zeitbezug zwischen Signal-Zweig A und B hergestellt wird. Ein fester Zeitbezug ist dann vorhanden, wenn in beiden Signal-Zweigen beim gleichen Triggerereignis die Post-Trigger-Zeit gestartet wird. Zuerst betrachte man das Gedankenexperiment in Fig. 8. In beiden Signal-Zweigen läuft jeweils ein Pre-Trigger-Zähler. Wenn jeder Signal-Zweig auf ein Triggerereignis reagiert, wenn der eigene Pre-Trigger-Zähler abgelaufen ist, ist der Zeitbezug zwischen den Signal-Zweigen unklar, weil unterschiedliche Triggerereignisse erkannt werden können. Selbst wenn die Schalter 30, 31 in Fig. 8 erst nach Ablauf beider Pre-Trigger-Zähler schließen, ist nicht sicher, ob beide Signal-Zweige auf das gleiche Triggerereignis reagieren, da die Verzögerungen in den beiden Pfaden sehr unterschiedlich sein können. Durch die unterschiedlichen Verzögerungen in den beiden Signal-Zweigen könnte z. B. das Triggerereignis, welches im Signal-Zweig B die Post-Trigger-Zeit startet, den Signal-Zweig A schon verlassen haben. Somit würde in diesem Beispiel der Signal-Zweig A auf ein anderes späteres Triggerereignis reagieren.

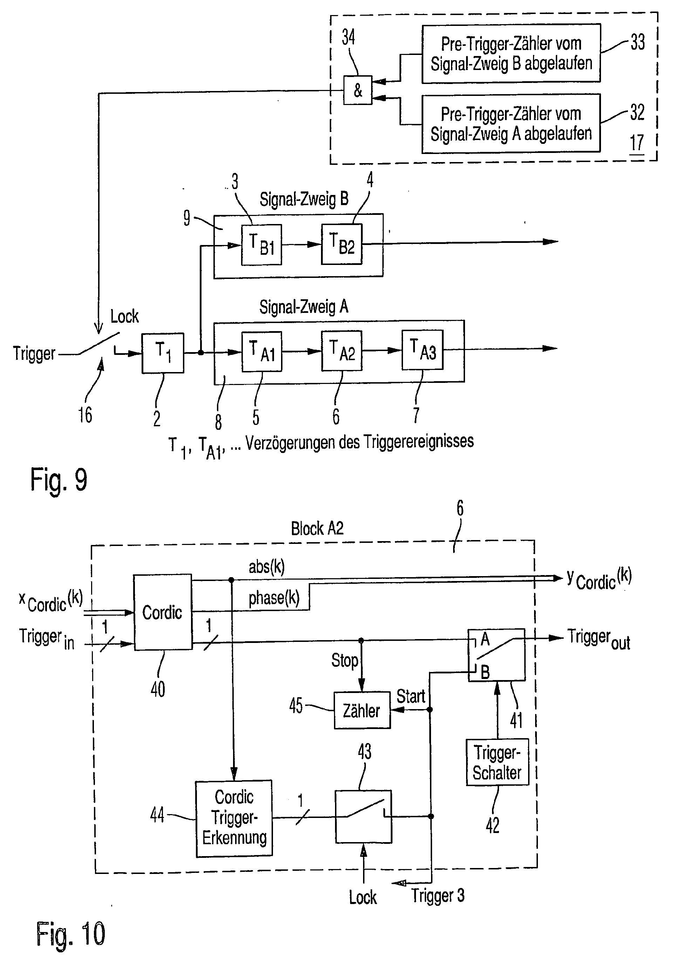

Wird der Triggereingang erst dann entsperrt, wenn beide Pre-Trigger-Zähler abgelaufen sind, dann ist sichergestellt, dass das erste durchgelassene Triggerereignis auch in beiden Zweigen die Post-Trigger-Zeit startet. Dieses Entsperren mit dem Steuersignal *Lock* muss aber vor der Stelle geschehen, an der sich die Eingangsdaten in die beiden Zweige aufteilen. Fig. 9 zeigt, wie durch die Pre-Trigger-Zähler die Eingänge gesperrt werden müssen. Es müssen erst die Pretrigger-Zähler 32, 33 beider Signal-Zweige abgelaufen sein müssen, bevor die Triggerung durch das Steuersignal *Lock* entsperrt wird. Dies ist in Fig. 9 durch das UND-Glied 34 veranschaulicht. Sobald ein Triggerereignis das Schalterelement 16 durchlaufen hat, muß das Schalterelement 16 wieder geöffnet werden, weil sonst der in den Blöcken 2 - 7 ermittelte Trigger-Offset überschrieben würde.

Neben dem Triggersignal *Trigger* 1 oder dem Software-Trigger *Trigger* 2 kann das interne Triggersignal *Trigger* 3 verwendet werden, was im folgenden genauer untersucht wird. Soll bei interner Triggererzeugung gleichzeitig auch ein fester Zeitbezug zwischen den beiden Signal-Zweigen bestehen, müssen weitere Regeln beachtet werden.

Zur besseren Erläuterung der internen Triggererzeugung wird als Beispiel der Cordic-Block 6 in Fig. 10 betrachtet. In der Cordic-Einheit 40 wird der Betrag *abs*(*k*) und die Phase *phase*(*k*) der Eingangsfolge berechnet. Überschreitet der Betrag einen vorgebbaren Schwellwert, wird ein internes Triggerereignis erzeugt.

Soll kein Zeitbezug zwischen den beiden Signalzweigen hergestellt werden, wird das interne Triggerereignis direkt auf den Ausgang des Cordic-Blocks gegeben. In diesem Fall wird Schalterstellung B für den Schalter 41 durch die Schaltersteuerung 42 gewählt. Da noch nicht klar ist, ob die Pre-Trigger-Zeit abgelaufen ist, da das Triggerereignis noch die restlichen Blöcke 7 zum Ausgang durchlaufen muss, müssen alle Triggerereignisse weitergeleitet werden. Erscheint dann ein solches Triggerereignis am Ausgang und ist die Pre-Trigger-Zeit abgelaufen, beginnt die Post-Trigger-Zeit.

Soll aber wieder ein Zeitbezug zwischen den beiden Signal-Zweigen bestehen, muss das in der Cordic-Einheit 40 erzeugte Triggerereignis in den Eingang der Signalverarbeitung über das Triggersignal *Trigger* 3 eingespeist werden, d. h. in diesem Fall wird nicht am Cordic-Block direkt ein Triggerereignis eingespeist. In diesem Fall wird Schalterstellung A für den Schalter 41 durch die Schaltersteuerung 42 gewählt. Am Eingang wird das Triggerereignis nur weitergeleitet, wenn die Pre-Trigger-Zeit in beiden Zweigen abgelaufen ist. Nach dem Ablaufen der Pre-Trigger-Zeiten wird das Steuersignal auf *Lock* = 1 aktiviert und der Schalter 43 geschlossen. Das von der Trigger-Erkennungseinrichtung 44 erkannte Triggerereignis durchläuft dann als Triggersignal *Trigger* 3 die beiden Zweige und löst die Post-Trigger-Zeit aus.

Bei dieser Betriebsart wird somit ein späterer Ausgangswert markiert, weil das Triggersignal auf den Eingang zurückgeführt wird. Damit ist das Triggerereignis um die Gruppenlaufzeitverzögerung der Blöcke 2 und 5 vor dem Cordic-Block 6 verzögert. Um dieses Problem zu lösen, startet im Cordic-Block 6 mit dem Erkennen des Triggerereignisses ein Zähler 45, der die Anzahl der Werte zählt, bis das eingespeiste Triggerereignis wieder im Cordic-Block 6 erscheint, und zwar an der gleichen Stelle, wo auch das Triggerereignis erkannt wurde und das Zählen begonnen hat. Damit wird der Zeitpunkt der Schwellwertüberschreitung durch Verschiebung der Markierung um die Zeit

$$dT = Z\ddot{a}hler \cdot T_{in}$$

in Richtung Vergangenheit rekonstruiert. Die Taktrate der Eingangs- und Triggerfolge im Cordic-Block 6 wird in der Formel mit $T_{in}$ bezeichnet.

Die Erfindung ist nicht auf das vorstehend beschriebene und in den Figuren der Zeichnung dargestellte Ausführungsbeispiel beschränkt, sondern eignet sich auch für andere Konfigurationen der Signalverarbeitung.

**Patentansprüche**

1. Digitale Signalverarbeitungsvorrichtung (1) mit einer ersten Signalverarbeitungseinheit (8) für einen ersten Signal-Zweig (A), deren Signalverarbeitungsergebnis in einem ersten Speicher (10) aufgezeichnet wird,

   zumindest einer parallel zu der ersten Signalverarbeitungseinheit (8) arbeitenden zweiten Signalverarbeitungseinheit (9) für einen zweiten Signal-Zweig (B), deren Signalverarbeitungsergebnis in einem zweiten Speicher (11) aufgezeichnet wird, und

   einer Aufzeichnungssteuerung (17) zur Steuerung der Aufzeichnung in dem ersten Speicher (10) und in dem zweiten Speicher (11),

   wobei die Aufzeichnungssteuerung (17) ein in einer Triggerleitung (20) vor den beiden parallel arbeitenden Signalverarbeitungseinheiten (8,9) angeordnetes Trigger-Schalterelement (16) so ansteuert, dass in beiden Speichern (10,11) im wesentlichen die gleiche Zeitperiode während einer Post-Trigger-Zeit nach einem Trigger-Zeitpunkt aufgezeichnet wird, wobei

   die Signalverarbeitungseinheiten (8,9) jeweils einen oder mehrere Signalverarbeitungsblöcke (3,4; 5,6,7) umfassen, wobei zumindest in einem der signalverarbeitungsblöcke eine verzögerung einer digitalen ausgengsfolge (y(k)) gegenüber einer Eingangsfolge (x(w)) auftritt, **dadurch gekennzeichnet, dass**, in jedem Signalverarbeitungsblock (3,4 ; 5,6,7), in welchem eine Verzögerung der digitalen Ausgangsfolge (y(k)) gegenüber der digitalen Eingangsfolge (x(k)) auftritt, das Triggersignal um einen Betrag verzögert wird, welcher der Gruppenlaufzeit der Eingangsfolge (x(k)) durch den betreffenden Signalverarbeitungsblock entspricht.

2. Digitale Signalverarbeitungsvorrichtung nach Anspruch 1,
   **dadurch gekennzeichnet,**
   **dass** eine Umschalteinrichtung (12) vorhanden ist, die ein Umschalten zwischen einem externen Trigger-Signal (Trigger 1) und/oder einem von der Aufzeichnungssteuerung (17) erzeugten ersten internen Trigger-Signal (Trigger 2) und/oder einem von einer der Signalverarbeitungseinheiten (8) erzeugten zweiten internen Trigger-Signal (Trigger 3) ermöglicht.

3. Digitale Signalverarbeitungsvorrichtung nach Anspruch 2,
   **dadurch gekennzeichnet,**
   **dass** eine flankensensitive Abtasteinheit (13) vorhanden ist, die das externe Trigger-Signal (Trigger 1) in Bezug auf ein Taktsignal flankensensitiv abtastet.

4. Digitale Signalverarbeitungsvorrichtung nach Anspruch 3,
   **dadurch gekennzeichnet,**
   **dass** der flankensensitiven Abtasteinheit (13) ein erstes Trigger-Offset-Register (14) nachgeschaltet ist, in welchen gespeichert wird, ob die ansteigende bzw. abfallende Flanke des externen Triggersignals (Trigger 1) in einem ersten Bereich (Bereich 1) oder in einem zweiten Bereich (Bereich 2) des Taktsignals auftrat.

5. Digitale Signalverarbeitungsvorrichtung nach einem der Ansprüche 1 bis 4,
   **dadurch gekennzeichnet,**
   **dass** in jedem Signalverarbeitungsblock (3,4; 5,6,7), in welchem eine Dezimation der digitalen Eingangsfolge (x(k)) durch Verringerung der Abtastrate erfolgt, in einem zugeordneten Trigger-Offset-Register (28) gespeichert wird, um welche Zeit das Triggersignal durch die Verringerung der Abtastrate verschoben wurde.

6. Digitale Signalverarbeitungsvorrichtung nach einem der Ansprüche 1 bis 5,
   **dadurch gekennzeichnet,**
   **dass** in der Aufzeichnungssteuerung (17) eine erste Zeiterfassungseinrichtung (32) zur Erfassung einer dem Trigger-Zeitpunkt mindestens vorausgehende Pre-Trigger-Zeit für den ersten Signal-Zweig (A) und eine zweite Zeiterfassungseinrichtung (33) zur Erfassung einer dem Trigger-Zeitpunkt mindestens vorausgehende Pre-Trigger-Zeit für den zweiten Signal-Zweig (B) vorhanden sind und dass das Trigger-Schalterelement (16) erst angesteuert wird, wenn die von beiden Zeiterfassungseinrichtungen (32,33) erfassten Pre-Trigger-Zeiten abgelaufen sind.

7. Digitale Signalverarbeitungsvorrichtung nach Anspruch 6,
   **dadurch gekennzeichnet,**
   **dass** die Ausgänge der Zeiterfassungseinrichtungen (32,33) durch ein logisches UND-Verknüpfungsglied (34) miteinander verbunden sind.

8. Digitale Signalverarbeitungsvorrichtung nach einem der Ansprüche 1 bis 7,

**dadurch gekennzeichnet,**
**dass** zumindest ein Signalverarbeitungsblock (6), vorhanden ist, der ein internes Trigger-Signal (Trigger 3) erzeugt.

9. Digitale Signalverarbeitungsvorrichtung nach Anspruch 8,
**dadurch gekennzeichnet,**
**dass** jeder Signalverarbeitungsblock (6), der ein internes Trigger-Signal (Trigger 3) erzeugt, eine Trigger-Erkennungseinrichtung (44) aufweist, der ein Trigger-Schalterelement (43) nachgeschaltet ist, das ein von der Trigger-Erkennungseinrichtung (44) erzeugtes Trigger-Signal (Trigger 3) nur dann zu den Signalverarbeitungseinheiten (8,9) passieren lässt, wenn es von der Aufzeichnungssteuerung (17) angesteuert wird.

10. Digitale Signalverarbeitungsvorrichtung nach Anspruch 8 oder 9,
**dadurch gekennzeichnet,**
**dass** jeder Signalverarbeitungsblock (6), der ein internes Trigger-Signal (Trigger 3) erzeugt, eine Zeiterfassungseinrichtung (45) aufweist, welche die Laufzeit des Trigger-Signals (Trigger 3) bis zu dem betreffenden Signalverarbeitungsblock (6) durch alle vorgeschalteten Signalverarbeitungsblöcke (2, 5) erfasst.


**Claims**

1. Digital signal-processing device (1) with a first signal-processing unit (8) for a first signal branch (A), of which the signal-processing result is recorded in a first memory (10),
with at least one second signal-processing unit (9) operating in parallel to the first signal-processing unit (8) for a second signal branch (B), of which the signal-processing result is recorded in a second memory (11), and
with a recording controller (17) for controlling the recording in the first memory (10) and in the second memory (11),
wherein the recording controller (17) drives a trigger-switching element (16), arranged in a trigger line (20) upstream of the two parallel-operating signal-processing units (8, 9), in such a manner that substantially the same timing period during a post-triggering period after a trigger time is recorded in both memories (10, 11), wherein the signal-processing units (8, 9) each comprise one or more signal-processing blocks (3,4; 5,6,7),
wherein, in at least one of the signal-processing blocks, a delay of a digital output sequence (y(k)) relative to an input sequence (x(k)) occurs,
**characterised in that,**
in every signal-processing block (3,4; 5,6,7) in which a delay of the digital output sequence (y(k)) relative to the digital input sequence (x(k)) occurs, the trigger signal is delayed by a value which corresponds to the group delay time of the input sequence (x(k)) through the relevant signal-processing block.

2. Digital signal-processing device according to claim 1,
**characterised in that**
a switchover device (12), which allows a switching between an external trigger signal (Trigger 1) and/or a first internal trigger signal (Trigger 2) generated by the recording controller (17) and/or a second internal trigger signal (Trigger 3) generated by one of the signal-processing units (8), is present.

3. Digital signal-processing device according to claim 2,
**characterised in that**
an edge-sensitive sampling unit (13), which samples the external trigger signal (Trigger 1) in an edge-sensitive manner with reference to a clock signal, is present.

4. Digital signal-processing device according to claim 3,
**characterised in that**
a first trigger-offset register (14), which stores, whether the rising or falling edge of the external trigger signal (Trigger 1) occurred in a first region (Region 1) or in second region (Region 2) of the clock signal, is connected downstream of the edge-sensitive sampling unit (13).

5. Digital signal-processing device according to any one of claims 1 to 4,
**characterised in that,**
in each signal-processing block (3,4; 5,6,7), in which a decimation of the digital input sequence (x(k)) takes place through a reduction of the sampling rate, an assigned trigger-offset register (28) stores the time, by which the trigger signal was displaced by the reduction of the sampling rate.

6. Digital signal-processing device according to any one of claims 1 to 5,
**characterised in that**
a first time-registering device (32) for registering a pre-triggering period at least preceding the trigger time for the first signal branch (A) and a second time-registering device (33) for registering a pre-triggering period at least preceding the trigger time for the second signal branch (B) are present in the recording controller (17), and that the trigger-switching element (16) is only driven, when the pre-triggering periods registered by the two time recording devices (32,33) have elapsed.

7. Digital signal-processing device according to claim 6,
**characterised in that**
the outputs of the time-registering devices (32, 33) are connected to one another by a logical AND linking element (34).

8. Digital signal-processing device according to any one of claims 1 to 7,
**characterised in that**
at least one signal-processing block (6), which generates an internal trigger signal (Trigger 3), is present.

9. Digital signal-processing device according to claim 8,
**characterised in that**
each signal-processing block (6), which generates an internal trigger signal (Trigger 3), provides a trigger-recognition device (44), downstream of which a trigger-switching element (43) is connected, which only allows a trigger signal (Trigger 3) generated by the trigger-recognition device (44) to pass to the signal-processing units (8,9), when it is driven by the recording controller (17).

10. Digital signal-processing device according to claim 8 or 9,
**characterised in that**
each signal-processing block (6), which generates an internal trigger signal (Trigger 3) provides a time-registering device (45), which registers the delay of the trigger signal (Trigger 3) up to the relevant signal-processing block (6) through all of the upstream-connected signal-processing blocks (2,5).

**Revendications**

1. Dispositif de traitement de signaux numériques (1) comportant
une première unité de traitement de signaux (8) pour une première branche de signal (A), dont le résultat de traitement de signaux est enregistré dans une première mémoire (10),
au moins une seconde unité de traitement de signaux (9) fonctionnant parallèlement à la première unité de traitement de signaux (8) pour une seconde branche de signal (B), dont le résultat de traitement de signal est enregistré dans une seconde mémoire (11), et
une commande d'enregistrement (17) pour commander l'enregistrement dans la première mémoire (10) et dans la seconde mémoire (11),
dans lequel la commande d'enregistrement (17) commande un élément de circuit de déclenchement (16) disposé dans une ligne de déclenchement (20) en amont des deux unités de traitement de signaux fonctionnant parallèlement (8, 9), de sorte qu'un enregistrement est effectué dans les deux mémoires (10, 11) pendant sensiblement la même période de temps pendant un temps de post-déclenchement après un temps de déclenchement, dans lequel
les unités de traitement de signaux (8, 9) comprennent respectivement un ou plusieurs blocs de traitement de signaux (3, 4 ; 5, 6, 7), dans lequel, au moins dans un des blocs de traitement de signaux, un retard d'une séquence de sortie numérique (y(k)) se produit par rapport à une séquence d'entrée (x(k)), **caractérisé en ce que**, dans chaque bloc de traitement de signaux (3, 4 ; 5, 6, 7), dans lequel se produit un retard de la séquence de sortie numérique (y(k)) par rapport à la séquence d'entrée numérique (x(k)), le signal de déclenchement est ralenti d'une quantité, qui correspond au temps de propagation de groupe de la séquence d'entrée (x(k)) à travers le bloc de traitement de signaux concerné.

2. Dispositif de traitement de signaux numériques selon la revendication 1, **caractérisé en ce que**
un dispositif de commutation (12) est prévu, qui permet une commutation entre un signal de déclenchement externe (Trigger 1) et/ou un premier signal de déclenchement interne (Trigger 2) généré par la commande d'enregistrement (17) et/ou un second signal de déclenchement interne (Trigger 3) généré par l'une des unités de traitement de signaux (8).

**3.** Dispositif de traitement de signaux numériques selon la revendication 2, **caractérisé en ce que**
une unité d'échantillonnage à bord sensible (13) est prévue, qui échantillonne par son bord sensible le signal de déclenchement externe (Trigger 1) par rapport à un signal d'horloge.

**4.** Dispositif de traitement de signaux numériques selon la revendication 3, **caractérisé en ce que**
l'unité d'échantillonnage à bord sensible (13) est montée en aval d'un premier registre à décalage de déclenchement (14), dans lequel il est mémorisé si le flanc montant ou descendant du signal de déclenchement externe (Trigger 1) apparaît dans une première zone (zone 1) ou dans une seconde zone (zone 2) du signal d'horloge.

**5.** Dispositif de traitement de signaux numériques selon l'une des revendications 1 à 4, **caractérisé en ce que**
dans chaque bloc de traitement de signaux (3, 4 ; 5, 6, 7), dans lequel une décimation de la séquence d'entrée numérique (x(k)) se produit par réduction du taux d'échantillonnage, il est enregistré dans un registre à décalage de déclenchement associé (28), à quel moment le signal de déclenchement est décalé par la réduction du taux d'échantillonnage.

**6.** Dispositif de traitement de signaux numériques selon l'une des revendications 1 à 5, **caractérisé en ce que**
dans la commande d'enregistrement (17), un premier dispositif de détection de temps (32) pour détecter un temps de pré-déclenchement pour la première branche de signal (A) provenant d'au moins du temps de déclenchement et un second dispositif de détection de temps (33) pour détecter un temps de pré-déclenchement pour la seconde branche de signal (B) provenant au moins du temps de déclenchement sont prévus et
**en ce que** l'élément de commutation de déclenchement (16) est commandé uniquement, lorsque les temps de pré-déclenchement détectés par les deux dispositifs de détection de temps (32, 33) sont écoulés.

**7.** Dispositif de traitement de signaux numériques selon la revendication 6, **caractérisé en ce que**
les sorties des dispositifs de détection de temps (32, 33) sont reliées l'une à l'autre par un élément logique ET (34).

**8.** Dispositif de traitement de signaux numériques selon l'une des revendications 1 à 7, **caractérisé en ce que**
au moins un bloc de traitement de signaux (6) est prévu, qui génère un signal de déclenchement interne (Trigger 3).

**9.** Dispositif de traitement de signaux numériques selon la revendication 8, **caractérisé en ce que**
chaque bloc de traitement de signaux (6), qui génère un signal de déclenchement interne (Trigger 3), présente un dispositif de reconnaissance de déclenchement (44), qui est monté en aval d'un élément de commutation de déclenchement (43), qui laisse passer un signal de déclenchement (Trigger 3) généré par le dispositif de reconnaissance de déclenchement (44) uniquement vers les unités de traitement de signaux (8, 9), lorsqu'il est commandé par la commande d'enregistrement (17).

**10.** Dispositif de traitement de signaux numériques selon la revendication 8 ou 9, **caractérisé en ce que**
chaque bloc de traitement de signaux (6), qui génère un signal de déclenchement interne (Trigger 3), présente une unité de détection de temps (45), qui détecte la durée du signal de déclenchement (Trigger 3) jusqu'au bloc de traitement de signaux concerné (6) à travers tous les blocs de traitement de signaux montés en amont (2, 5).

Fig. 1

ab jetzt wird auf
Triggerereignisse reagiert

Beginn der
Aufzeichnung

Pre-Trigger-Zeit

Post-Trigger-Zeit

Ende der
Aufzeichnung

t

unterdrückte Triggerereignisse

unterdrückte Triggerereignisse

dieses Triggerereignis
wird erkannt

## Fig. 2

Bereich 1   Bereich 2

Eingangstakt

Ergebnis
Trigger

Kein Trigger

00

Trigger im Bereich 1

11

Trigger im Bereich 2

10

## Fig. 3

Eingangstakt

Trigger 1

Trigger wird im Resampler dem Eingangswert B zugeordnet

Trigger wird im Resampler dem Eingangswert F zugeordnet

Daten am Eingang

| A | B | C | D | E | F | G |

Zugeordnetes Triggersignal

| $00_{BIN}$ | $10_{BIN}$ | $00_{BIN}$ | $11_{BIN}$ | $00_{BIN}$ |

## Fig. 4

Block mit 4 Pipline-Register — 24

20  21  22  23

x(k) → Pipl.-Reg. → • • • → Pipl.-Reg. → • • • → Pipl.-Reg. → • • • → Pipl.-Reg. → y(k)

Trigger$_{in}$ → Pipl.-Reg. → • • • → Pipl.-Reg. → • • • → Pipl.-Reg. → • • • → Pipl.-Reg. → Trigger$_{out}$

Systemtakt

x(k)  | x(10) | x(11) | x(12) | x(13) | x(14) | x(15) | x(16) | x(17) | x(18) |

Trigger$_{in}$

y(k)  | y(6) | y(7) | y(8) | y(9) | y(10) | y(11) | y(12) | y(13) | y(14) |

Trigger$_{out}$

Durch Trigger markierter Abtastwert

## Fig. 5

Block mit Dezimation

26

down = 4

x(k) → Signalverarbeitung ohne Dezimation → y(k) → 27 → $y_{dez}$ (l)

25

Trigger$_{in}$(k) → Triggerereignis verschieben, Offset speichern → Trigger$_{out}$ (l)

28 — Trigger-Offset-Register

auslesbar

## Fig. 6

Pre-Trigger-Zähler vom Signal-Zweig B abgelaufen

3    Signal-Zweig B    4

9

$T_{B1}$ → $T_{B2}$ → 31

Signal-Zweig A

Trigger → $T_1$ → $T_{A1}$ → $T_{A2}$ → $T_{A3}$ → 30

2    8    5    6    7

Pre-Trigger-Zähler vom Signal-Zweig A abgelaufen

$T_1$, $T_{A1}$, ... Verzögerungen des Triggerereignisses

## Fig. 8

Fig. 7

$T_1$, $T_{A1}$, ... Verzögerungen des Triggerereignisses

**Fig. 9**

**Fig. 10**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10159911 A1

- EP 1156338 A